# EUROPEAN PATENT APPLICATION

(11) **EP 4 746 600 A1**
(43) Date of publication of application: **20.05.2026**
(21) Application number: 24921431.3
(22) Date of filing: 11.09.2024
(51) Int. Cl.: H05K 5/02

(54) **FLEXIBLE CIRCUIT BOARD AND ELECTRONIC DEVICE**

(30) Priority: 31.01.2024 CN 202410142592
(71) Applicant: Huawei Technologies Co., Ltd., Shenzhen, Guangdong 518129 (CN)
(72) Inventor: LONG, Teng, Shenzhen, Guangdong 518129 (CN); YI, Yuan, Shenzhen, Guangdong 518129 (CN); DUAN, Kaijun, Shenzhen, Guangdong 518129 (CN); WANG, Qiyuan, Shenzhen, Guangdong 518129 (CN); LI, Shaohua, Shenzhen, Guangdong 518129 (CN)
(74) Representative: Pfenning, Meinig & Partner mbB
(86) International application number: PCT/CN2024/118187
(87) International publication number: WO 2025/161406

(57) **Abstract**

This application provides a flexible printed circuit and an electronic device. The electronic device includes a first housing and a second housing; a hinge component, including a first structural member and a second structural member that are rotatably connected, where the second structural member is connected to the second housing, the first structural member is connected to the first housing, and a channel communicating first accommodation space formed on the first housing and second accommodation space formed on the second housing is disposed on the first structural member; and a flexible printed circuit, including a first end, a second end, and a first section and a second section that are located between the first end and the second end, where the first end is connected to a first electronic element accommodated in the first accommodation space, the second end is connected to a second electronic element accommodated in the second accommodation space, the first section is located in the channel and is fastened to the first structural member, and the second section is located in the second accommodation space and a minimum bending radius of the second section is greater than or equal to a preset value. According to the technical solutions, appearance delicacy of a hinge can be improved while a reliable electrical connection is implemented by using the hinge.

## Description

This application claims priority to Chinese Patent Application No. 202410142592.4, filed with the China National Intellectual Property Administration on January 31, 2024 and entitled "FLEXIBLE PRINTED CIRCUIT AND ELECTRONIC DEVICE", which is incorporated herein by reference in its entirety.

### TECHNICAL FIELD

This application relates to the field of electronic device technologies, and more specifically, to a flexible printed circuit and an electronic device.

### BACKGROUND

Many electronic devices have hinges, and the electronic devices may be unfolded and folded via the hinges. An electrical signal further needs to be transmitted between two parts of the electronic device that are connected via the hinge. Currently, a cable (for example, a bundled cable or a flat cable) is usually used to pass through a channel disposed on the hinge to electrically connect the two parts that are connected via the hinge. However, because a size of the cable is large, to enable the cable to pass through the hinge, a size of the hinge needs to be very large. Consequently, appearance delicacy of the hinge is insufficient.

### SUMMARY

This application provides a flexible printed circuit and an electronic device, to improve appearance delicacy of a hinge while ensuring that a reliable electrical connection is implemented by using the hinge.

According to a first aspect, an electronic device is provided, including a first device body component, including a first housing and a first electronic element, where first accommodation space is formed on the first housing, and the first electronic element is accommodated in the first accommodation space; a second device body component, including a second housing and a second electronic element, where second accommodation space is formed on the second housing, and the second electronic element is accommodated in the second accommodation space; a hinge component, including a first structural member and a second structural member that are rotatably connected, where the second structural member is connected to the second housing, the first structural member is connected to the first housing, and a channel communicating the first accommodation space with the second accommodation space is disposed on the first structural member; and a flexible printed circuit, including a first end, a second end, and a first section and a second section that are located between the first end and the second end, where the first end is connected to the first electronic element, the second end is connected to the second electronic element, the first section is located in the channel and is fastened to the first structural member, and the second section is located in the second accommodation space and a minimum bending radius of the second section is greater than or equal to a preset value.

In this embodiment of this application, the flexible printed circuit is used as a signal line, so that space can be saved, a size of the hinge component can be reduced, and appearance delicacy of the hinge component can be improved. The second section that is of the flexible printed circuit and that is located in the second accommodation space is a free part and has the bending radius greater than or equal to the preset value. The second section is not prone to crease or breakage in unfolding and folding processes of the electronic device, so that a service life of the flexible printed circuit can be prolonged, and reliability of an electrical connection can be ensured.

With reference to the first aspect, in some implementations of the first aspect, rebound force of the flexible printed circuit is greater than or equal to 40 mN/mm and less than or equal to 100 mN/mm.

The second section has proper rebound force, so that it can be ensured that the second section maintains a specific bending radius in the unfolding and folding processes of the electronic device, to avoid that a crease is easily generated due to excessively low rebound force, or a problem that smoothness of motion of the hinge component is affected or the hinge component easily breaks due to excessively high rebound force.

With reference to the first aspect, in some implementations of the first aspect, the preset value is greater than or equal to five times a thickness of the flexible printed circuit.

The bending radius of the second section is large, so that stress concentration is avoided, the flexible printed circuit is not prone to a crease, a risk of breaking a metal wire is reduced, and the service life of the flexible printed circuit is longer.

With reference to the first aspect, in some implementations of the first aspect, the second section performs crawler motion with unfolding and folding motion of the electronic device.

The crawler motion makes it difficult to generate a crease in the second section, and can maintain consistency of motion trajectories in the second section. In this way, the service life of the flexible printed circuit can be prolonged, thereby improving reliability of the flexible printed circuit.

With reference to the first aspect, in some implementations of the first aspect, a part other than the second section on the flexible printed circuit is relatively fastened.

In this way, only the second section is a movable part. This helps ensure motion reliability of the flexible printed circuit.

With reference to the first aspect, in some implementations of the first aspect, the flexible printed circuit includes a first cover film, a metal conductive layer, a substrate layer, and a second cover film that are stacked, the metal conductive layer is located between the first cover film and the substrate layer, and the substrate layer is located between the metal conductive layer and the second cover film.

The flexible printed circuit is single-layer routing. This can meet a signal transmission requirement, and has good bending resistance performance, so that the service life of the flexible printed circuit can be prolonged.

With reference to the first aspect, in some implementations of the first aspect, a material of the metal conductive layer is rolled annealed copper.

The rolled annealed copper is used as the conductive layer of the flexible printed circuit, so that a dynamic bending requirement of the flexible printed circuit can be met.

With reference to the first aspect, in some implementations of the first aspect, the metal conductive layer is located on a bent inner side of the second section relative to the substrate layer.

The metal conductive layer is placed on the bent inner side, so that a long-term dynamic bending requirement of the flexible printed circuit can be ensured, and the reliability of the flexible printed circuit can be improved.

With reference to the first aspect, in some implementations of the first aspect, the hinge component further includes: a wedge-shaped member, where the wedge-shaped member is disposed at an end part that is of the channel and that is located in the second accommodation space, and is located between the first section and an inner wall that is of the channel and that is away from a pivotal line of the hinge component.

The wedge-shaped member is disposed, so that a part that is of the first section and that is close to an outlet of the channel is closely attached to the inner wall that is of the channel and that is close to an axis center of the hinge. This helps form the large bending radius for the second section.

With reference to the first aspect, in some implementations of the first aspect, the wedge-shaped member is wedged to the first structural member, or the wedge-shaped member is fastened to the first structural member.

With reference to the first aspect, in some implementations of the first aspect, the first structural member includes a main body and a cover body, the main body and the cover body are snap-fitted to form the channel, and the wedge-shaped member is located between the first section and the first cover body.

The channel is formed by using split structures that are snap-fitted, to facilitate assembly of the flexible printed circuit.

With reference to the first aspect, in some implementations of the first aspect, the second section is U-shaped when the electronic device is in an unfolded state.

With reference to the first aspect, in some implementations of the first aspect, a protective film is disposed in a region that is on the second section and that is in contact with an inner wall of the second housing and/or a region that is on the second housing and that is in contact with the second section.

The protective film has good abrasion resistance performance, and can protect a surface of the flexible printed circuit from scratches and damage.

With reference to the first aspect, in some implementations of the first aspect, the first structural member includes: a first fastening part, connected to the first housing; a mandrel, where an axis of the mandrel is the pivotal line of the hinge component; and a connection part, connecting the first fastening part to the mandrel, where the channel is disposed at the connection part. The second structural member includes: a second fastening part, connected to the second housing; and a shaft sleeve, sleeved on the mandrel, and configured to support the mandrel to rotate around the pivotal line.

The connection part is disposed, so that a protrusion structure can be formed on the hinge component, and the first device body component is lifted upward with respect to the second device body component when the electronic device is unfolded.

With reference to the first aspect, in some implementations of the first aspect, the connection part includes a first partial section and a second partial section, the first partial section is connected to the first fastening part, the second partial section is connected to the mandrel, and there is a preset included angle between the first partial section and the second partial section.

When the signal line passes through the channel, rotation of the mandrel is not affected.

With reference to the first aspect, in some implementations of the first aspect, the first partial section is of an arc-shaped structure.

The arc-shaped structure is used, so that space can be softened, appearance can be improved, and motion is smooth. This facilitates push-pull motion of the flexible printed circuit.

With reference to the first aspect, in some implementations of the first aspect, a central angle corresponding to the first partial section is greater than or equal to 90° and less than or equal to 180°.

In this way, an unfolding and folding angle of the electronic device can reach 90° to 180°.

With reference to the first aspect, in some implementations of the first aspect, the electronic device includes one or more layers of flexible printed circuits, and second sections on adjacent flexible printed circuits in the plurality of layers of flexible printed circuits are separable from each other with the unfolding and folding motion of the electronic device.

In this way, when the electronic device is unfolded and folded, the plurality of flexible printed circuits do not interfere with each other during motion, and the bending radius of the second section and force applied to the metal wire are not affected, so that the flexible printed circuit meets a bending reliability requirement.

With reference to the first aspect, in some implementations of the first aspect, parts other than the second sections on the adjacent flexible printed circuits in the plurality of layers of flexible printed circuits are correspondingly fastened and stacked.

With reference to the first aspect, in some implementations of the first aspect, a quantity of layers of the flexible printed circuit is greater than or equal to 1 and less than or equal to 5.

A width of the hinge component can be further reduced by using the plurality of layers of flexible printed circuits, and more transmitted signals can be added.

With reference to the first aspect, in some implementations of the first aspect, the hinge component is a protruding hinge.

This can facilitate disposing of various ports and heat dissipation holes at the rear of the second device body component.

With reference to the first aspect, in some implementations of the first aspect, the first electronic element is any one of a display drive board, a camera, or a microphone, and the second electronic element is a main board.

According to a second aspect, a hinge component is provided, used in an electronic device. The electronic device includes a first housing and a second housing. The hinge component includes a first structural member and a second structural member that are rotatably connected, where the second structural member is configured to be connected to the second housing, the first structural member is configured to be connected to the first housing, and a channel communicating first accommodation space formed on the first housing and second accommodation space formed on the second housing is disposed on the first structural member; and a wedge-shaped member, where the wedge-shaped member is disposed at an end part that is of the channel and that is located in the second accommodation space, and is located between a flexible printed circuit passing through the channel and an inner wall that is of the channel and that is away from a pivotal line of the hinge component.

With reference to the second aspect, in some implementations of the second aspect, the wedge-shaped member is wedged to the first structural member, or the wedge-shaped member is fastened to the first structural member.

With reference to the second aspect, in some implementations of the second aspect, the wedge-shaped member is fastened to the inner wall that is of the channel and that is away from the pivotal line of the hinge component.

With reference to the second aspect, in some implementations of the second aspect, the first structural member includes a main body and a cover body, the main body and the cover body are snap-fitted to form the channel, and the wedge-shaped member is located between the cover body and the flexible printed circuit passing through the channel.

With reference to the second aspect, in some implementations of the second aspect, the first structural member includes: a first fastening part, configured to be connected to the first housing; a mandrel, where an axis of the mandrel is the pivotal line of the hinge component; and a connection part, connecting the first fastening part to the mandrel, where the channel is disposed at the connection part. The second structural member includes: a second fastening part, configured to be connected to the second housing; and a shaft sleeve, sleeved on the mandrel, and configured to support the mandrel to rotate around the pivotal line.

With reference to the second aspect, in some implementations of the second aspect, the connection part includes a first partial section and a second partial section, the first partial section is connected to the first fastening part, the second partial section is connected to the mandrel, and there is a preset included angle between the first partial section and the second partial section.

With reference to the second aspect, in some implementations of the second aspect, the first partial section is of an arc-shaped structure.

With reference to the second aspect, in some implementations of the second aspect, a central angle corresponding to the first partial section is greater than or equal to 90° and less than or equal to 180°.

With reference to the second aspect, in some implementations of the second aspect, the hinge component is a protruding hinge.

According to a third aspect, a flexible printed circuit is provided. The flexible printed circuit is the flexible printed circuit according to the first aspect and any one of the possible implementations of the first aspect, or is the flexible printed circuit according to the second aspect and any one of the possible implementations of the second aspect.

For beneficial effect of the apparatuses in the second aspect and the third aspect, refer to related descriptions in the first aspect. For brevity, details are not described again.

### BRIEF DESCRIPTION OF DRAWINGS

FIG. 1 is a diagram of a structure of an electronic device to which embodiments of this application are applicable;
FIG. 2 is a sectional view of an electronic device in a folded state according to an embodiment of this application;
FIG. 3 is a sectional view of an electronic device in an unfolded state according to an embodiment of this application;
FIG. 4 is a diagram of a method for measuring rebound force of a flexible printed circuit according to an embodiment of this application;
FIG. 5 is a diagram of a structure of a flexible printed circuit according to an embodiment of this application;
FIG. 6 is a diagram of a structure of a hinge component according to an embodiment of this application;
FIG. 7 is a diagram of a structure of a first structural member in a hinge component according to an embodiment of this application;
FIG. 8 is a diagram of an unfolded state and a folded state of a hinge component according to an embodiment of this application; and
FIG. 9 is a diagram of stacked layers of a flexible printed circuit according to an embodiment of this application.

### DESCRIPTION OF EMBODIMENTS

The following describes technical solutions of this application with reference to accompanying drawings.

It should be noted that, in descriptions of embodiments of this application, unless otherwise specified, "/" means "or". For example, A/B may indicate A or B. "And/or" in this specification merely describes an association relationship between associated objects, and indicates that three relationships may exist. For example, A and/or B may indicate the following three cases: Only A exists, both A and B exist, and only B exists.

Terms "first", "second", and the like in embodiments of this application are merely intended for a purpose of description, and shall not be understood as an indication or implication of relative importance or implicit indication of a quantity of indicated technical features. Therefore, a feature limited by "first", "second", or the like may explicitly or implicitly include one or more features. In addition, in the descriptions of embodiments of this application, "a plurality of" means two or more, and "at least one" and "one or more" mean one, two, or more. Singular expression forms "one", "a", "the", "the foregoing", "this", and "the one" are also intended to include expression forms such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "have", and their variants all mean "include but are not limited to", unless otherwise specifically emphasized in another manner.

In the descriptions of embodiments of this application, orientations or position relationships indicated by terms "up", "down", "inside", "outside", "vertical", "horizontal", and the like are defined relative to orientations or positions in which components are schematically placed in the accompanying drawings. It should be understood that these directional terms are relative concepts, and are used for relative description and clarification, but not indicate or imply that a specified apparatus or component needs to have a specific orientation or be constructed and operated in a specific orientation. These directional terms may vary based on changes of positions of the components in the accompanying drawings, and therefore cannot be understood as a limitation on this application. In addition, "vertical" in this application is not strictly vertical, but is vertical within an allowed error range. "Parallel" is not strictly parallel, but within an allowable error range.

In embodiments of this application, a same reference numeral indicates a same part. For same parts in embodiments of this application, only one part marked with a reference numeral may be used as an example in the figure. It should be understood that the reference numeral is also applicable to another same part. In addition, for brevity, detailed descriptions of same parts are omitted in different embodiments. In addition, the parts in the accompanying drawings are not drawn to actual scale. Dimensions and sizes of the parts shown in the figures are merely examples, and should not be understood as a limitation on this application.

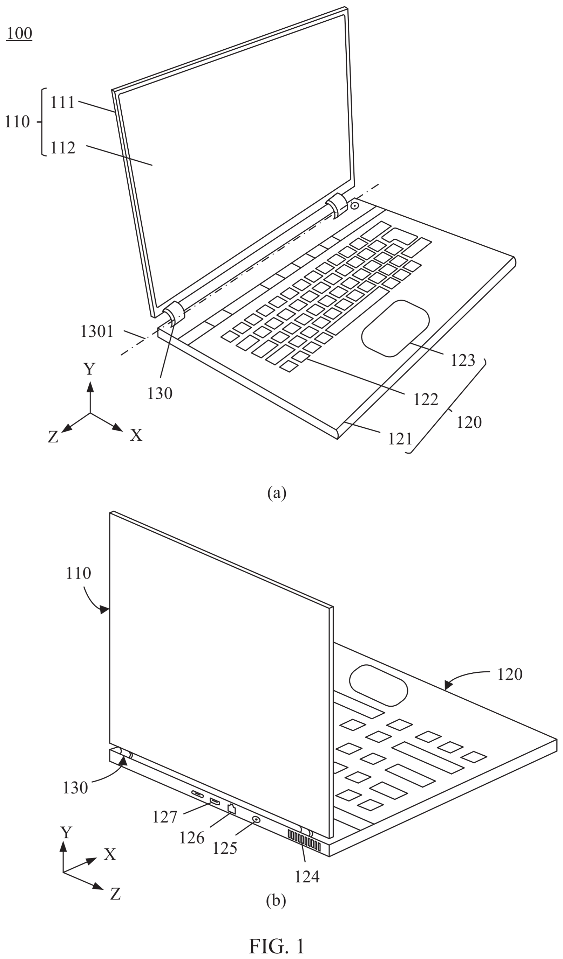

FIG. 1 is a diagram of a structure of an electronic device 100 to which an embodiment of this application is applicable. (a) and (b) in FIG. 1 are diagrams of structures of the electronic device 100 from different angles of view.

In this embodiment of this application, the electronic device 100 may be a handheld device, a vehicle-mounted device, a wearable device, a computing device, a portable device, or the like. For example, the electronic device 100 includes but is not limited to a tablet computer, a luggable computer, a laptop computer (laptop computer), a notebook computer, a two-in-one computer, a cellular phone (cellular phone), a television (television) (or smart screen), a smartphone (smartphone), a personal digital assistant (personal digital assistant, PDA) computer, a digital camera, a smart watch (smart watch), a smart wristband (smart wristband), a vehicle-mounted computer, a desktop computer, a portable computer, a calculator, another electronic device having a plurality of hinged housing parts, and the like. A specific form of the electronic device 100 is not specially limited in embodiments of this application. For ease of description and understanding, an example in which the electronic device 100 is a portable computer is used below for description.

Refer to FIG. 1. The electronic device 100 may include a first device body component 110, a second device body component 120, and a hinge component 130.

For ease of description, the following defines a direction parallel to a pivotal line (namely, an axis center of the hinge) of the hinge component as a Z direction, a direction parallel to a main plane of the second device body component 120 (namely, a surface with a largest area in the second device body component 120) and perpendicular to the Z direction as an X direction, and a direction perpendicular to the main plane of the second device body component 120 and perpendicular to the Z direction as a Y direction. Herein, definitions of the X, Y, and Z directions are also applicable to the accompanying drawings to be described below. It should be noted that the definitions of the X, Y, and Z directions are merely intended to facilitate description of a location relationship and a connection relationship between components in embodiments of this application, and should not be construed as a limitation on embodiments of this application.

As shown in (a) in FIG. 1, the first device body component 110 includes a first housing 111. First accommodation space is formed on the first housing 111, and the first accommodation space is used to accommodate an electronic component disposed on a side of the first device body component 110. The first housing 111 can further protect the electronic device, dissipate heat, and the like.

A material of the first housing 111 may be a metal material, for example, an aluminum alloy, a magnesium alloy, an aluminum-magnesium alloy, a titanium alloy, or austenitic stainless steel. Alternatively, the material of the first housing 111 may be a non-metal material, for example, carbon fiber, polycarbonate (polycarbonate, PC), engineering plastic, glass, ceramic, wood, leather, sapphire, or a composite material.

Electronic components accommodated in the first housing 111 include but are not limited to a display, a camera, an antenna, a speaker, a processor, a memory, a sensor, and the like. For ease of description, in this embodiment of this application, a component that is disposed on the side of the first device body component 110 and that needs to be electrically connected is referred to as a first electronic element. The first electronic element may also be understood as a component disposed on the first housing 111.

For example, as shown in (a) in FIG. 1, the first electronic element disposed on the side of the first device body component 110 includes a display 112. The display 112 is accommodated in the first accommodation space formed on the first housing 111, and is connected to the first housing 111.

The display 112 is configured to display an image. The display 112 may be a liquid crystal display (liquid crystal display, LCD), an organic light-emitting diode (organic light-emitting diode, OLED) display, or the like. The OLED display may be a flexible display or a rigid display. For example, the display 112 may be but is not limited to an active-matrix organic light emitting diode (active-matrix organic light emitting diode, AMOLED) display, a flexible light-emitting diode (flexible light-emitting diode, FLED) display, a mini light-emitting diode (mini light-emitting diode, Mini-LED) display, a micro light-emitting diode (micro light-emitting diode, Micro-LED) display, a micro organic light-emitting diode (micro organic light-emitting diode, Micro-OLED) display, a quantum dot light-emitting diode (quantum dot light-emitting diode, QLED) display, and the like.

The display 112 may be a common regular screen, or may be a special-shaped screen, a foldable screen, or the like. This is not limited in this embodiment of this application. The display 112 may be a touch panel (touch panel) that can implement a touch input, or may be a non-touch panel. This is not limited in this embodiment of this application. The display 112 is provided with a light-emitting surface that can display an image. In this embodiment of this application, a surface on a side that is on the display 112 and that is disposed opposite to the light-emitting surface is referred to as a back surface of the display 112. The back surface of the display 112 is accommodated in the first accommodation space, and is not seen by a user.

In some embodiments, the first device body component 110 on which the display 112 is disposed may also be referred to as a display end, a display part, or a screen side.

As shown in (a) in FIG. 1, the second device body component 120 includes a second housing 121. Second accommodation space is formed on the second housing 121, and the second accommodation space is used to accommodate an electronic component disposed on a side of the second device body component 120. The second housing 121 can further protect the electronic device, dissipate heat, and the like.

A material of the second housing 121 may be a metal material, for example, an aluminum alloy, a magnesium alloy, an aluminum-magnesium alloy, a titanium alloy, or austenitic stainless steel. Alternatively, the material of the second housing 121 may be a non-metal material, for example, carbon fiber, polycarbonate (polycarbonate, PC), engineering plastic, glass, ceramic, wood, leather, sapphire, or a composite material. The materials of the second housing 121 and the first housing 111 may be the same or may be different. This is not limited in this embodiment of this application.

Electronic components accommodated in the second housing 121 include but are not limited to an antenna, a processor, a memory, a ventilation fan, a keyboard, a touchpad, a battery, a main board, and the like. For ease of description, in this embodiment of this application, a component that is disposed on the side of the second device body component 120 and that needs to be electrically connected is referred to as a second electronic element. The second electronic element may also be understood as a component disposed on the second housing 121.

For example, as shown in (a) in FIG. 1, the second electronic element disposed on the side of the second device body component 120 includes an input device, for example, a keyboard 122 or a touchpad 123. The input device is accommodated in the second accommodation space formed on the second housing 121, and is connected to the second housing 121, to implement human-computer interaction.

In some embodiments, the electronic device 100 may further include another input device, for example, a mouse, a handwriting input device, a voice input device, a scanner, a light pen, or a joystick. Details are not described herein. It should be noted that the camera disposed on the electronic device and the display 112 with a touch function are also input devices.

In some embodiments, the second device body component 120 on which the keyboard 122 is disposed may also be referred to as a keyboard end, a keyboard part, or a system side.

The hinge component 130 is hinged between the first device body component 110 and the second device body component 120. The hinge component 130 includes a pivotal line 1301 (which may also be referred to as an axis center of the hinge), and the hinge component 130 can implement rotation of the first device body component 110 around the pivotal line 1301 relative to the second device body component 120, or rotation of the second device body component 120 around the pivotal line 1301 relative to the first device body component 110, to fold (or close) and unfold the electronic device 100.

In other words, the first device body component 110 and the second device body component 120 are separately attached to the hinge component 130, and the hinge component 130 allows the first device body component 110 and the second device body component 120 to rotate relative to each other around the pivotal line 1301 of the hinge component 130. For example, the hinge component 130 enables the first device body component 110 to rotate around the pivotal line 1301 relative to the second device body component 120, so that the electronic device 100 can switch between a folded state and an unfolded state.

In this embodiment of this application, an edge of the first housing 111 and an edge of the second housing 121 are separately attached to the hinge component 130, and the first housing 111 and the second housing 121 may rotate relative to each other around the pivotal line 1301. In this way, the first electronic element disposed on the first housing 111 and the second electronic element disposed on the second housing 121 can rotate relative to each other around the pivotal line 1301. In this embodiment of this application, a motion state of the first housing 111 may be equivalent to a motion state of the first device body component 110, and a motion state of the second housing 121 may be equivalent to a motion state of the second device body component 120. Because the edges of the first housing 111 and the second housing 121 are hinged via the hinge component 130, the first housing 111 and the second housing 121 may be in a stacked state, or may be in an unfolded state and have an included angle.

For example, when the electronic device 100 is folded, an included angle between the first device body component 110 and the second device body component 120 may approach 0°, and two surfaces (for example, the light-emitting surface of the display 112 and the keyboard 122) that form the included angle on the first device body component 110 and the second device body component 120 are close to each other. When the electronic device 100 is in the folded state, the display 112 and the keyboard 122 may be accommodated in the accommodation space formed on the first housing 111 and the second housing 121.

For another example, when the electronic device 100 is unfolded, the included angle between the first device body component 110 and the second device body component 120 may approach 90° to 180°, or may be a larger angle, for example, 270° or 360°, and the two surfaces (for example, the light-emitting surface of the display 112 and the keyboard 122) that form the included angle on the first device body component 110 and the second device body component 120 are away from each other. When the electronic device 100 is in the unfolded state, the display 112 and the input device (for example, the keyboard 122 and the touchpad 123) may be exposed for use by the user.

In some embodiments, when the included angle between the first device body component 110 and the second device body component 120 is greater than a preset angle, in a process in which the first device body component 110 rotates around the pivotal line 1301 relative to the second device body component 120, the first device body component 110 may stay in any position.

In some embodiments, when the included angle between the first device body component 110 and the second device body component 120 is less than or equal to the preset angle, the first device body component 110 is in an unbalanced state, and may automatically approach the second device body component 120, to make the electronic device 100 finally in the folded state.

It should be understood that the included angle between the first device body component 110 and the second device body component 120 may be understood as an unfolding and folding angle of the hinge component 130.

Certainly, in some embodiments, the included angle between the first device body component 110 and the second device body component 120 may be considered as an included angle between a plane on which the light-emitting surface of the display 112 is located and a plane on which a tapping surface of the keyboard 122 is located.

In some embodiments, the included angle between the first device body component 110 and the second device body component 120 may also be considered as an included angle between the first housing 111 and the second housing 121. Specifically, the included angle may be an included angle between a plane on which the first housing 111 is located and a plane on which the second housing 121 is located. In this embodiment of this application, the plane on which the first housing 111 is located may be considered as a plane on which a part with a largest area on the first housing 111 is located (which may also be referred to as a main plane of the first housing 111). Similarly, the plane on which the second housing 121 is located may be considered as a plane on which a part with a largest area on the second housing 121 is located (which may also be referred to as a main plane of the second housing 121).

In this embodiment of this application, the hinge component 130 is a protruding hinge, or referred to as a horn hinge. A feature of the hinge component 130 is that when the electronic device 100 is unfolded, the first device body component 110 is lifted upward with respect to the second device body component 120, so that the first device body component 110 does not block the rear of the second device body component 120. This can facilitate disposing of various ports and heat dissipation holes at the rear of the second device body component 120. In addition, the protruding hinge is not easily blocked during rotation, so that an angle at which the screen can be unfolded is large, and can usually reach at least 150° to 180°.

In some embodiments, as shown in (b) in FIG. 1, heat dissipation holes 124 may be disposed at the rear of the second device body component 120, and the heat dissipation holes 124 can improve heat dissipation efficiency of the electronic device 100, to create a more stable performance output environment. The heat dissipation holes 124 may include an air intake hole and/or an air exhaust hole. The air intake hole is configured to inhale cold air, and the air exhaust hole is configured to exhaust hot air inside the electronic device 100.

In some embodiments, as shown in (b) in FIG. 1, at least one interface, for example, a power interface 125, a network interface 126, a universal serial bus (universal serial bus, USB) port 127, a display interface, an audio interface (for example, a headset interface), and a memory card interface may be disposed at the rear of the second device body component 120.

The USB port 127 is configured to connect to various external digital devices such as a mouse, a USB flash drive, a keyboard, a printer, and a scanner. The USB port 127 includes but is not limited to an A-type port (Type-A or USB-A), a B-type port (Type-B or USB-B), and a Type-C port (Type-C or USB-C). The power interface 125 is configured to supply power to or charge the electronic device 100, and may be a round hole, a square hole, or USB-C in appearance. The display interface is configured to connect to a device like an external display or a projector. When the screen of the electronic device 100 is insufficient to meet a use requirement, another screen may be extended through the display interface. The memory card interface is configured to read information of a memory card (for example, a secure digital card (secure digital card, SD), a multimedia card (multimedia card, MMC), or a memory stick (memory stick, MS)).

It may be understood that the electronic components disposed on the side of the first device body component 110 and the electronic components disposed on the side of the second device body component 120 may be completely the same, may be partially the same, or may be completely different. The foregoing is merely an example for description.

For example, the first device body component 110 may include a first display, and the second device body component 120 may include a second display. When the electronic device is folded, a light-emitting surface of the first display is opposite to a light-emitting surface of the second display. In this way, the electronic device 100 is a dual-screen device.

It should be understood that FIG. 1 merely shows examples of some components included in the electronic device 100, and shapes, sizes, and structures of these components are not limited in FIG. 1. In some other embodiments, the electronic device 100 may further include more or fewer components than those shown in the figure. This is not limited in this embodiment of this application. In some other embodiments, a type of the electronic device 100 is different and components included in the electronic device 100 are different. A structure of the electronic device provided in this embodiment of this application is merely an example for description.

In this embodiment of this application, in addition to a mechanical connection between the first device body component 110 and the second device body component 120 via the hinge component 130, in some embodiments, the first device body component 110 and the second device body component 120 further need to be electrically connected, to transmit a signal between the first device body component 110 and the second device body component 120. Usually, an electrical signal connection in a scenario in which the hinge is lifted upward is more difficult than that in a scenario in which the hinge is not lifted upward given that the electrical signal connection in the scenario in which the hinge is lifted upward has a higher requirement on electrical connection reliability.

In an existing solution, a cable passing through a channel disposed on the hinge component is used to connect the system side to the screen side. The cable is a bundled cable (namely, formed by bundling a dozen or dozens of coaxial cables) or a flat cable (namely, formed by flatly arranging a dozen or dozens of coaxial cables), and can be pulled at will. However, because a size of the cable is large, to enable the cable to pass through the hinge component, a size of the hinge component needs to be very large. Consequently, appearance delicacy of the hinge component is insufficient. For example, the bundled cable is thick. As a result, a thickness (a size in a direction perpendicular to the axis center of the hinge component) of the hinge component is large. For another example, the flat cable is wide. As a result, a width (a size in a direction of the axis center of the hinge component) of the hinge component is large. Limited by a diameter of a single coaxial cable, a thickness of the entire flat cable also limits the thickness of the hinge component. In addition, with improvement of a screen specification and integration of a camera, a microphone, and the like on the screen side, signals that need to be transmitted between the system side and the screen side gradually increase. Consequently, a size of the hinge component further needs to be increased.

In view of this, embodiments of this application provide a hinge component and an electronic device, to improve appearance delicacy of the hinge while ensuring that a reliable electrical connection is implemented by using the hinge.

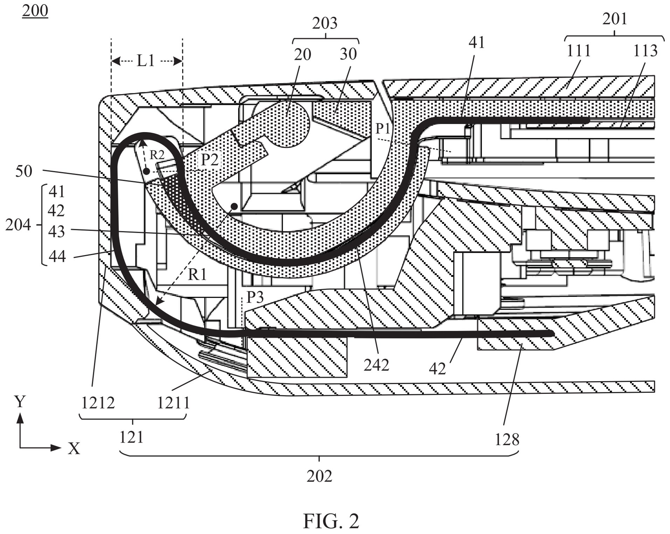

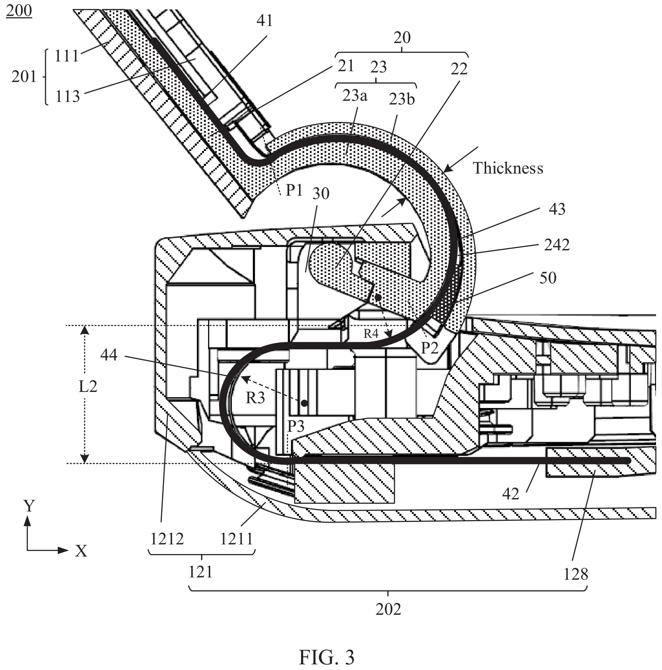

FIG. 2 and FIG. 3 each are a sectional view of an electronic device according to an embodiment of this application. FIG. 2 is a sectional view of an electronic device 200 in a folded state according to an embodiment of this application. FIG. 3 is a sectional view of the electronic device 200 in an unfolded state according to an embodiment of this application. The electronic device 200 shown in FIG. 2 and FIG. 3 may be an example of the electronic device 100 shown in FIG. 1.

Refer to FIG. 2 and FIG. 3. The electronic device 200 may include a first device body component 201, a second device body component 202, a hinge component 203, and a flexible printed circuit (flexible printed circuit, FPC) 204.

The first device body component 201 includes a first housing 111 and a first electronic element 113. First accommodation space is formed on the first housing 111 forms, and the first electronic element 113 is accommodated in the first accommodation space. The first electronic element 113 is any component that needs to be electrically connected to an electronic element in the second device body component 202, for example, a display drive board, a microphone, a camera, or a circuit board. For descriptions of the first housing 111, refer to the related descriptions in FIG. 1. For brevity, details are not described herein again.

The second device body component 202 includes a second housing 121 and a second electronic element 128. Second accommodation space is formed on the second housing 121, and the second electronic element 128 is accommodated in the second accommodation space. The second electronic element 128 is any component electrically connected to the first electronic element 113, for example, a main board or a circuit board. For descriptions of the second housing 121, refer to the related descriptions in FIG. 1. For brevity, details are not described herein again.

The hinge component 203 is hinged between the first device body component 201 and the second device body component 202, and the first device body component 201 may rotate around an axis center of the hinge relative to the second device body component 202 via the hinge component 203. More specifically, the hinge component 203 is hinged between the first housing 111 and the second housing 121, and the first housing 111 and the second housing 121 may rotate relative to each other around the axis center of the hinge of the hinge component 203.

As shown in FIG. 2 and FIG. 3, the hinge component 203 may include a first structural member 20 and a second structural member 30, and the first structural member 20 is rotatably connected to the second structural member 30. In addition, the first structural member 20 is connected to the first housing 111, and the second structural member 30 is connected to the second housing 121. A channel 242 communicating the first accommodation space with the second accommodation space is disposed on the first structural member 20, and the channel 242 is used for the flexible printed circuit 204 to pass through. One end of the channel 242 is located in the first accommodation space formed on the first housing 111, and the other end is located in the second accommodation space formed on the second housing 121.

The flexible printed circuit 204 passes through the channel 242, and may electrically connect the first electronic element to the second electronic element, to implement electrical signal transmission between the first device body component 201 and the second device body component 202.

As shown in FIG. 2 and FIG. 3, the flexible printed circuit 204 may include a first end 41, a second end 42, and a first section 43 and a second section 44 that are located between the first end 41 and the second end 42. The first end 41 is connected to the first electronic element 113, and the second end 42 is connected to the second electronic element 128. The first section 43 is located in the channel 242 and is fastened to the first structural member 20, and the second section 44 is located in the second accommodation space and a minimum bending radius of the second section 44 is greater than or equal to a preset value.

For ease of understanding, in FIG. 2 and FIG. 3, section division is schematically performed on the flexible printed circuit 204 by using dashed lines. For example, a dashed line P2 is a division boundary between the first section 43 and the second section 44, a dashed line P1 is a division boundary between the first section 43 and a part of the flexible printed circuit located between the first end 41 and the first section 43 or a division boundary between the first section 43 and the first end 41, and a dashed line P3 is a division boundary between the second section 44 and a part of the flexible printed circuit located between the second end 42 and the second section 44 or a division boundary between the second section 44 and the second end 42. It may be understood that the division boundaries shown in the figure are merely examples, and constitute no limitation on this application.

In this embodiment of this application, the flexible printed circuit 204 is used as a signal line, and the flexible printed circuit 204 is much thinner than a bundled cable or a flat cable, so that space can be saved, a size of the hinge component 203 can be reduced, and appearance delicacy of the hinge component 203 can be improved. Specifically, the flexible printed circuit 204 is usually thin. Therefore, a size of the channel 242 that is disposed on the hinge component 203 and that is used for the flexible printed circuit 204 to pass through does not need to be very large. For example, a thickness of the channel 242 in a direction perpendicular to the axis center of the hinge and/or a width of the channel 242 in a direction of the axis center of the hinge may be reduced. Correspondingly, the size of the hinge component 203 is reduced, so that the appearance delicacy of the hinge component 203 can be improved.

The flexible printed circuit is a circuit board made of a thin film material, and has features of high bendability and foldability. However, in a bending process of the flexible printed circuit, a crease problem often occurs, a breakage probability increases, and performance and reliability of the circuit board are affected. In this embodiment of this application, a part that is of the flexible printed circuit 204 and that passes through the hinge component 203 and a part connected to the housings (for example, the first housing 111 and the second housing 121) of the electronic device 200 are relatively fastened, and the second section 44 that is of the flexible printed circuit 204 and that is located in the second accommodation space is a free part and has the bending radius greater than or equal to the preset value. In this way, the second section 44 can meet a requirement of electrical signal transmission on a length of the signal line, and has the bending radius that is not excessively small. Correspondingly, the flexible printed circuit 204 is not prone to a crease or breakage in unfolding and folding processes of the electronic device 200, so that a service life of the flexible printed circuit 204 can be prolonged, and reliability of the electrical connection can be ensured.

It should be noted that, in this embodiment of this application, the minimum bending radius of the second section 44 is a minimum bending radius of the second section 44 in all states. In other words, the second section 44 has specific bending radii in both a static state and a motion state, and the minimum bending radius is greater than or equal to the preset value. For example, as shown in FIG. 2, when the electronic device 200 is folded, the second section 44 may include a part having a bending radius R1 and a part having a bending radius R2. Alternatively, as shown in FIG. 3, when the electronic device 200 is unfolded, the second section 44 may include a part having a bending radius R3 and a part having a bending radius R4. It may be understood that the bending radii shown in FIG. 2 and FIG. 3 are merely examples, and constitute no limitation on this application.

In some embodiments, a part other than the second section 44 on the flexible printed circuit 204 is relatively fastened, for example, fastened to at least one of the first housing 111, the second housing 121, and the first structural member 20.

In some embodiments, relative degrees of freedom of motion of the second section 44 include a first degree of freedom of translation and a second degree of freedom of translation on a plane (for example, an XY plane shown in FIG. 3) perpendicular to the axis center of the hinge, and a degree of freedom of bending around the axis center of the hinge. The first degree of freedom of translation is perpendicular to the second degree of freedom of translation. For example, the first degree of freedom of translation may be a degree of freedom of translation in an X direction, the second degree of freedom of translation may be a degree of freedom of translation in a Y direction, and the degree of freedom of bending may be a degree of freedom of bending around a Z axis.

It may be understood that the degree of freedom of bending in this embodiment of this application means that the second section 44 may be bent under a bending moment.

In some embodiments, with unfolding and folding motion of the electronic device 200, the second section 44 performs crawler motion under traction force.

Specifically, with reference to FIG. 2 and FIG. 3, when the electronic device 200 switches from the unfolded state shown in FIG. 3 to the folded state shown in FIG. 2, the first structural member 20 and the first housing 111 connected to the first structural member 20 rotate around the axis center of the hinge (for example, the Z axis). Correspondingly, the first section 43 that is of the flexible printed circuit 204 and that is fastened to the first structural member 20 also rotates around the axis center of the hinge. In a motion process of the first section 43, a part that is of the first section 43 and that is connected to the second section 44 provides acting force, namely, the traction force, for the second section 44. The second section 44 moves freely, the second section 44 is connected to the second housing 121, and the second section 44 has specific rebound force. Under the traction force, a part that is of the second housing 121 and that is connected to the second section 44 provides acting force opposite to a direction of the traction force for the second section 44. In this way, under the traction force and the reacting force, the crawler motion of the second section 44 can be implemented, and an area in which the second section 44 is in contact with an inner wall of the second housing 121 gradually increases. Similarly, when the electronic device 200 switches from the folded state shown in FIG. 2 to the unfolded state shown in FIG. 3, the area in which the second section 44 is in contact with the inner wall of the second housing 121 gradually decreases.

In this embodiment of this application, the second section 44 has the specific rebound force. Therefore, in the unfolding and folding processes of the electronic device 200, the second section 44 may always maintain a specific bending radius. Herein, there are two purposes of maintaining the specific bending radius of the second section 44 during motion. One is to prevent the second section 44 from easily generating the crease, and the other is to maintain consistency of motion trajectories (or motion paths) of the second section 44. In this way, the service life of the flexible printed circuit 204 can be prolonged, thereby improving the reliability of the flexible printed circuit 204.

In some embodiments, the rebound force of the second section 44 is greater than or equal to 40 millinewtons per millimeter (unit: mN/mm) and less than or equal to 100 mN/mm.

In some embodiments, rebound force of the flexible printed circuit 204 is greater than or equal to 40 mN/mm and less than or equal to 100 mN/mm.

It may be understood that the rebound force is force that is generated when an object is subject to external force and that is opposite to the external force, so that the object is restored to an original state. The rebound force of the flexible printed circuit 204 is related to a stacked structure of the flexible printed circuit 204 and an elastic modulus of a material of each film layer. The rebound force may be considered as a material characteristic of the flexible printed circuit. After the stacked structure and the material of the film layer of the flexible printed circuit are determined, the rebound force of the flexible printed circuit is determined. A unit of the rebound force is a magnitude of acting force in a unit length, for example, millinewton/millimeter. In this embodiment of this application, the second section 44 has proper rebound force, so that it can be ensured that the second section 44 maintains a specific bending radius in the unfolding and folding processes of the electronic device 200, to avoid that a crease is easily generated or a motion form of the second section 44 cannot be ensured due to excessively low rebound force (which may be understood as soft), or a problem that smoothness of motion of the hinge component 203 is affected or the hinge component 203 easily breaks due to excessively high rebound force (which may be understood as hard), and as a result, the service life of the flexible printed circuit is affected.

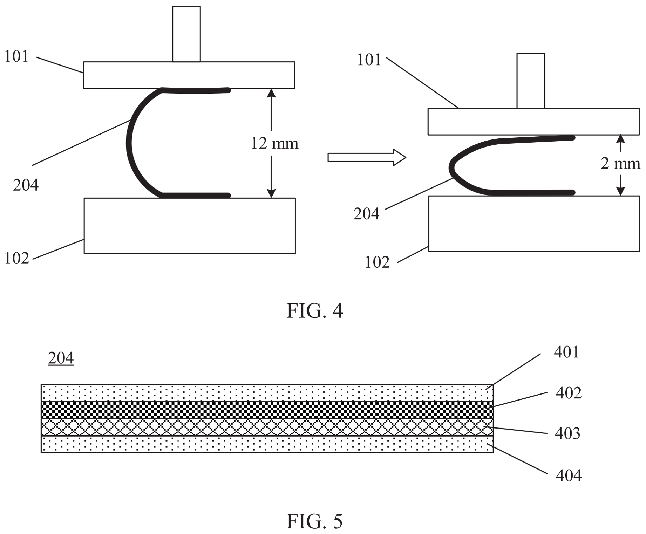

In some embodiments, a method for testing the rebound force of the flexible printed circuit 204 (or the second section 44) may be a U-shaped method. For example, as shown in FIG. 4, steps of testing the rebound force are as follows: (1) Two ends of the flexible printed circuit 204 are folded and placed in a U shape (that is, placed horizontally) between an upper jig 101 and a lower jig 102, where a distance between the upper jig 101 and the lower jig 102 is 12 mm; (2) press the upper jig 101 at a speed of 5 mm/min, and stop in a position 2 mm away from the lower jig 102; and (3) obtain an eigenvalue (maximum instantaneous value), namely, the rebound force, in a unit of mN/mm.

Certainly, in some other embodiments, the rebound force of the flexible printed circuit 204 may alternatively be determined by using another rebound force test method, for example, a resiliometer test method. Details are not described herein.

In some embodiments, the minimum bending radius of the second section 44 is greater than or equal to five times a thickness of the flexible printed circuit 204 (or second section 44). Correspondingly, the preset value may be greater than or equal to five times the thickness of the flexible printed circuit 204 (or second section 44). The bending radius of the second section 44 is large, so that stress concentration is avoided, and the flexible printed circuit is not prone to a crease. Correspondingly, force applied to the metal wire is small, a risk of breaking the metal wire is reduced, and the service life of the flexible printed circuit is longer.

FIG. 5 is a diagram of a structure of the flexible printed circuit 204 according to an embodiment of this application. The rebound force of the flexible printed circuit 204 can meet the foregoing condition.

As shown in FIG. 5, the flexible printed circuit 204 may include a first cover film 401, a metal conductive layer 402, a substrate layer 403, and a second cover film 404 that are stacked. The metal conductive layer 402 is located above the substrate layer 403, the first cover film 401 is located on a side that is of the metal conductive layer 402 and that is away from the substrate layer 403, and the second cover film 404 is located on a side that is of the substrate layer 403 and that is away from the metal conductive layer 402. In other words, the metal conductive layer 402 is disposed between the first cover film 401 and the substrate layer 403, and the substrate layer 403 is disposed between the metal conductive layer 402 and the second cover film 404.

The first cover film 401 and the second cover film 404 are configured to: isolate the metal conductive layer 402, prevent a short circuit and interference, and provide electrical insulation performance of the flexible printed circuit 204. The metal conductive layer 402 is configured to provide a conductive path required by the circuit board. The substrate layer 403 is configured to provide support for the metal conductive layer 402.

In some embodiments, a material of the first cover film 401 and/or the second cover film 404 is polyimide (polyimide, PI), polyethylene terephthalate (polyethylene terephthalate, PET), or the like. The PI has good high-temperature resistance performance and can work normally at a high temperature. The PET is cost-effective.

In some embodiments, a material of the metal conductive layer 402 is copper (for example, a copper foil). The copper foil has good electricity conductivity and processability.

For example, a material of the metal conductive layer 402 is rolled annealed copper. The rolled annealed copper is a product (a thickness usually ranges from 4 micrometers to 100 micrometers, and a width is usually less than 800 millimeters) formed by repeatedly rolling and annealing a high-precision copper strip (a thickness is usually less than 150 micrometers) by using a plastic processing principle. A crystal is of a sheet-like structure with good ductility, bending resistance, and electricity conductivity. The rolled annealed copper is used as the conductive layer of the flexible printed circuit 204, so that a dynamic bending requirement of the flexible printed circuit can be met.

It may be understood that the structure of the flexible printed circuit shown in FIG. 5 is merely an example. In some other embodiments, the flexible printed circuit 204 may further include another film layer, for example, an adhesive layer, a reinforcement material, or a protective film. Alternatively, some film layers are reduced. For example, the second cover film 404 is used to undertake a function of the substrate layer 403, and the substrate layer 403 is omitted.

Usually, the rebound force of the flexible printed circuit 204 can be adjusted by adjusting an elastic modulus of the material of each film layer of the flexible printed circuit 204. For example, an elastic modulus of a film layer may be changed by changing a proportion of components included in a material of the film layer.

The flexible printed circuit 204 provided in this embodiment of this application includes one metal conductive layer. In other words, the flexible printed circuit 204 is single-layer routing. This can meet a signal transmission requirement, and has good bending resistance performance, so that the service life of the flexible printed circuit can be prolonged.

In some embodiments, when the flexible printed circuit 204 shown in FIG. 5 is used in the electronic device 200, the metal conductive layer 402 is located on a bent inner side relative to the substrate layer 403. Usually, metal is resistant to extrusion force but is not resistant to pulling force. The metal conductive layer 402 is placed on the bent inner side, so that a long-term dynamic bending requirement of the flexible printed circuit 204 can be ensured, and the reliability of the flexible printed circuit 204 can be improved.

It should be noted that the bent inner side in this application may be understood as a side on which most curvature centers are located in a dynamic bending process of the second section 44. Actually, during motion of most lengths of the second section 44, curvature centers are located on a same side of the second section 44. In this way, reliability of at least most lengths of the second section 44 can be ensured. In some cases, a curvature center of an end part that is of the second section 44 and that is close to the first section 43 may change from one side of the second section 44 to the other side during motion. However, a length of the end part is short and a bending radius is large, and impact of pulling force applied to the metal conductive layer 402 on the service life may be ignored.

In some embodiments, refer to FIG. 2 or FIG. 3. The hinge component 203 may further include a wedge-shaped member 50. The wedge-shaped member 50 is disposed at an end part that is of the channel 242 and that is located in the second accommodation space, and is located between the first section 43 and an inner wall (referred to as a first inner wall below for ease of description) that is of the channel 242 and that is away from the axis center of the hinge. A size of a part that is of the wedge-shaped member 50 and that is close to an outlet of the channel 242 is greater than a size of a part that is of the wedge-shaped member 50 and that is away from the outlet of the channel 242, so that a part that is of the first section 43 and that is close to the outlet of the channel 242 can be closely attached to an inner wall (referred to as a second inner wall below for ease of understanding) that is of the channel 242 and that is close to the axis center of the hinge. In this way, the second section 44 (especially the part that is of the second section 44 and that is connected to the first section 43) forms a large bending radius, for example, the bending radius R2 shown in FIG. 2.

In some embodiments, the wedge-shaped member 50 is wedged to the first structural member 20. Correspondingly, the end part that is of the channel 242 and that is located in the second accommodation space includes a wedge-shaped opening that fits the wedge-shaped member 50. In this embodiment, the wedge-shaped member 50 is detachably connected to the first structural member 20.

In some other embodiments, the wedge-shaped member 50 is fastened to the first structural member 20. For example, the wedge-shaped member 50 and the first structural member 20 are connected through welding, riveting, screw threads, bonding, or snap-fitting. In this embodiment, the wedge-shaped member 50 and the first structural member 20 are detachably connected or non-detachably connected.

In some embodiments, a material of the wedge-shaped member 50 may be rubber, plastic, metal, or the like.

In some embodiments, refer to FIG. 2 and FIG. 3. The second housing 121 may include a bottom wall 1211 and a rear wall 1212, the bottom wall 1211 is connected to the rear wall 1212, the second section 44 is accommodated in accommodation space formed between the bottom wall 1211 and the rear wall 1212, and the accommodation space is subspace of the second accommodation space. Herein, the rear wall 1212 is wall at the rear of the electronic device 200 in a use state. For example, the rear wall 1212 is parallel to the axis center of the hinge.

As shown in FIG. 2, there is a first distance L1 between an end part (namely, a motion start point of the second section 44) that is of the second section 44 and that is connected to the first section 43 and the rear wall 1212. As shown in FIG. 3, there is a second distance L2 between the end part (namely, the motion start point of the second section 44) that is of the second section 44 and that is connected to the first section 43 and an end part (namely, a motion end point of the second section 44) that is of the second section 44 and that is connected to the second housing 121. Motion space of the second section 44 may be controlled by controlling a minimum value of the first distance L1 and a minimum value of the second distance L2. In other words, the motion space of the second section 44 may be determined based on the first distance L1 and the second distance L2. For example, when the electronic device 200 is folded, the value of the first distance L1 is the smallest. When another condition is fixed, a larger minimum value of the first distance L1 indicates larger motion space of the second section 44, and correspondingly, a larger minimum bending radius of the second section 44 and a longer service life of the flexible printed circuit 204. For another example, when the electronic device 200 is unfolded at a specific angle, the value of the second distance L2 is the smallest. When another condition is fixed, a larger minimum value of the second distance L2 indicates larger motion space of the second section 44, and correspondingly, a larger minimum bending radius of the second section 44 and a longer service life of the flexible printed circuit 204.

In some embodiments, the second section 44 is approximately U-shaped when the electronic device 200 is in the unfolded state, that is, is folded at 180°.

In this embodiment, the movable part (namely, the second section 44) of the flexible printed circuit 204 is constrained between an outlet of the tail of the hinge component 203 (namely, an outlet end that is of the channel 242 and that is accommodated in the second accommodation space) and a fastened point of the second housing 121, and the second section 44 is assembled to be folded at 180°, so that the second section 44 can perform U-shaped crawler motion between the two fastened points. A distance (namely, the second distance L2) between the two fastened points and a gap (namely, the first distance L1) between the tail of the hinge component 203 and the rear wall 1212 are adjusted, so that the second section 44 can maintain a specific bending radius in an entire motion process.

In some embodiments, a heat dissipation hole (for example, an air intake vent and/or an air exhaust vent) and/or at least one interface may be disposed on the rear wall 1212. The interface herein includes but is not limited to a power interface, a network interface, a display interface, an audio interface, a USB port, a memory card interface, and the like.

In some embodiments, the second section 44 includes a redundant length. The redundant length can ensure that the second section 44 always has a specific bending radius in the unfolded state, the folded state, and the unfolding and folding processes of the electronic device 200, and a case in which the second section 44 is straightened or the electronic device cannot be unfolded at a preset maximum angle due to an insufficient length of the second section 44 does not occur.

In some embodiments, anti-friction processing is performed in a contact region between the flexible printed circuit 204 and another component. For example, a protective film is disposed.

As an example instead of a limitation, a Mylar (mylar) film is disposed in a region that is of the flexible printed circuit 204 and that is in contact with the inner wall of the second housing 121 and/or a region that is of the second housing 121 and that is in contact with the flexible printed circuit 204. The Mylar (mylar) film has good abrasion resistance performance, and can protect a surface of the flexible printed circuit 204 from scratches and damage.

For example, the Mylar film is disposed on a side that is of the rear wall 1212 and/or the second section 44 and that faces the inner wall of the second housing 121.

As mentioned above, the first section 43 is located in the channel 242 and is fastened to the first structural member 20. In this way, the flexible printed circuit 204 can be prevented from moving inside the channel 242. There are a plurality of manners in which the first section 43 is fastened to the first structural member 20.

For example, the first section 43 may be bonded to the first structural member 20. Specifically, the first section 43 is bonded to an inner wall of the channel 242.

For another example, the first section 43 may be fastened to the first structural member 20 via a fastener. For example, refer to FIG. 3. The first structural member 20 may include a main body 23a and a cover body 23b. The main body 23a and the cover body 23b are snap-fitted to form the channel 242. After the first section 43 is placed in the channel 242, there is interference fit between the first section 43 and the main body 23a and between the first section 43 and the cover body 23b, so that the first section 43 is fastened. The channel 242 is formed by using split structures that are snap-fitted, to facilitate assembly of the flexible printed circuit 204.

In some embodiments, at least a part between the first end 41 and the first section 43 of the flexible printed circuit 204 may be fastened to the first housing 111, for example, fastened through bonding or clamping.

In some embodiments, at least a part between the second end 42 and the second section 44 of the flexible printed circuit 204 may be fastened to the second housing 121, for example, fastened through bonding or clamping.

In some embodiments, the first end 41 of the flexible printed circuit 204 may be fastened to the first electronic element 113 through the connection to the first electronic element 113. The second end 42 of the flexible printed circuit 204 may be fastened to the second electronic element 128 through the connection to the second electronic element 128.

In some embodiments, when the hinge component 203 includes the wedge-shaped member 50, the wedge-shaped member 50 may be fastened to the cover body 23b.

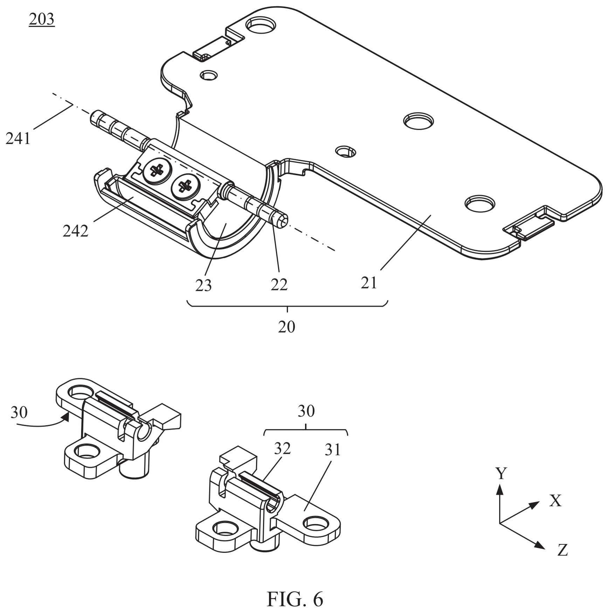

FIG. 6 is a diagram of a structure of a hinge component according to an embodiment of this application. The hinge component 203 shown in FIG. 6 may be used in the electronic device 100 shown in FIG. 1 or the electronic device 200 shown in FIG. 2. The hinge component 203 may be an example of the hinge component 130 shown in FIG. 1.

As shown in FIG. 6, the hinge component 203 may include the first structural member 20 and the second structural member 30. The first structural member 20 is configured to be connected to the first device body component 201 (which may be specifically the first housing 111), and the second structural member 30 is configured to be connected to the second device body component 202 (which may be specifically the second housing 121). The first structural member 20 and the second structural member 30 are rotatably connected. Specifically, the first structural member 20 and the second structural member 30 may rotate relative to each other around a pivotal line 241 (namely, the axis center of the hinge).

In this embodiment of this application, the channel 242 is further disposed on the first structural member 20, the channel 242 communicates the first accommodation space on a side of the first device body component 201 with the second accommodation space on a side of the second device body component 202, and the channel 242 is used for the signal line to pass through, so that electrical signal transmission between the side of the first device body component 201 and the side of the second device body component 202 is implemented.

In some embodiments, refer to FIG. 6. The first structural member 20 may include a first fastening part 21, a mandrel 22, and a connection part 23. The first fastening part 21 is configured to be fastened to the first housing 111, an axis 241 of the mandrel 22 (a center line of the mandrel) is the pivotal line of the hinge component, and the connection part 23 is configured to connect the first fastening part 21 to the mandrel 22. When the mandrel 22 rotates around the pivotal line 241 under external force, the connection part 23 may drive the first fastening part 21 to rotate around the pivotal line 241, and the connection part 23 also simultaneously rotates around the pivotal line 241. Similarly, when the first fastening part 21 rotates around the pivotal line 241 under external force, the connection part 23 may drive the mandrel 22 to rotate around the pivotal line 241, and the connection part 23 also simultaneously rotates around the pivotal line 241. The connection part 23 is disposed, so that a protrusion structure can be formed on the hinge component 203, and the first device body component 201 is lifted upward with respect to the second device body component 202 when the electronic device is unfolded.

In this embodiment of this application, when the hinge component 203 is used in the electronic device, the first fastening part 21 is disposed in the first accommodation space, the mandrel 22 is disposed in the second accommodation space, and the first fastening part 21 and the mandrel 22 are not seen by a user. At least a part of the connection part 23 may be accommodated in the second accommodation space as the electronic device is folded, or may be exposed to the outside and seen by the user as the electronic device is unfolded.

In some embodiments, the channel 242 is disposed at the connection part 23. When the signal line passes through the channel 242, rotation of the mandrel 22 is not affected.

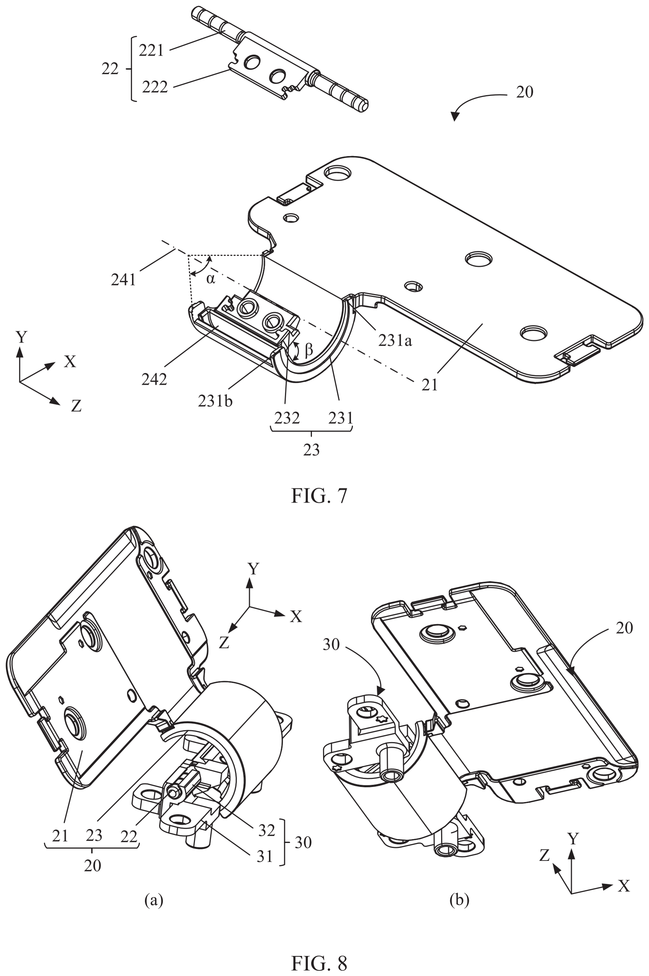

In some embodiments, refer to FIG. 7. The connection part 23 may include a first partial section 231 and a second partial section 232. The first partial section 231 is configured to be connected to the first fastening part 21, and the second partial section 232 is configured to be connected to the mandrel 22. Specifically, the first partial section 231 is fastened to or integrally formed with the first fastening part 21, and the second partial section 232 is fastened to or integrally formed with the mandrel 22. In other words, for the first partial section 231, two ends of the first partial section 231 in a circumferential direction of the pivotal line 241 are respectively connected to the first fastening part 21 and the second partial section 232. For example, the first partial section 231 includes a third end 231a and a fourth end 231b that are disposed in the circumferential direction of the pivotal line 241, the third end 231a is connected to the first fastening part 21, and the fourth end 231b is connected to the second partial section 232.

In some embodiments, the first partial section 231 is of a curved structure. Specifically, the first partial section 231 extends along a curve in a cross section perpendicular to the pivotal line 241. Correspondingly, the first partial section 231 includes at least one curvature radius in the circumferential direction of the pivotal line 241. When the first partial section 231 includes a plurality of curvature radii, it may be considered that the curvature radius of the first partial section 231 changes.

For example, the first partial section 231 may be of an arc-shaped structure. Specifically, the first partial section 231 is arc-shaped in the cross section perpendicular to the pivotal line 241. Correspondingly, the first partial section 231 has a fixed curvature radius in the circumferential direction of the pivotal line 241. The first partial section 231 is a part that can be seen by the user after the electronic device is unfolded. The first partial section 231 uses the arc-shaped structure, so that space can be softened, appearance can be improved, and motion is smooth. This facilitates push-pull motion of the flexible printed circuit.

It should be noted that the curvature radius of the first partial section 231 in this application may be a curvature radius of a surface that is of the first partial section 231 and that faces the mandrel 22, a curvature radius of a surface that is of the first partial section 231 and that is away from the mandrel 22, or a curvature radius of a surface between a surface that is of the first partial section 231 and that faces the mandrel 22 and a surface that is of the first partial section 231 and that is away from the mandrel 22. This is not limited in this application.

In some embodiments, an angle (an angle α shown in FIG. 7, namely, a central angle corresponding to an arc) of the first partial section 231 is greater than or equal to 90° and less than or equal to 180°. Correspondingly, a radian of the first partial section 231 is greater than or equal to π/2 and less than or equal to π. An unfolding and folding angle of the electronic device is equal to the angle of the first partial section 231. In this way, the unfolding and folding angle of the electronic device can reach 90° to 180°, for example, 120° or 135°, to meet an unfolding and folding of the screen. A larger angle at which the screen can be unfolded and folded may bring more use forms by combining with a touchable operation function of the screen.

It may be understood that the angle α in this application may be an included angle between connection lines of the two end parts (namely, the first end part 231a and the second end part 231b) of the first partial section 231 to the pivotal line 241.

In some embodiments, there is a preset included angle (an included angle β shown in FIG. 7) between the first partial section 231 and the second partial section 232. In this embodiment, it may be understood that the second partial section 232 is bent toward a side of the mandrel 22 relative to the first partial section 231 to form the preset included angle.

It may be understood that the included angle β in this application is an included angle between two connected parts (for example, the first partial section 231 and the second partial section 232) at a joint (for example, between end parts that are at the first partial section 231 and the second partial section 232 and that are used to connect to each other).

For example, the preset included angle may be less than or equal to 120°. Further, the preset included angle may be less than or equal to 90°.

In some embodiments, the first partial section 231 is fastened to or integrally formed with the second partial section 232.

In some embodiments, as shown in FIG. 7, the channel 242 may be disposed in the first partial section 231 of the connection part 23. Because the included angle β is formed between the first partial section 231 and the second partial section 232, when the signal line passes through the channel 242, the signal line does not interfere with motion of the mandrel 22.

In some embodiments, refer to FIG. 7. The mandrel 22 may include a main mandrel part 221 and an extension part 222 that extends from an outer wall of the main mandrel part 221 to a direction perpendicular to an axis of the pivotal line 241. The main mandrel part 221 is configured to fit the second structural member 30 to implement rotation of the mandrel 22, and the extension part 222 is configured to be connected to the connection part 23. For example, the extension part 222 is configured to be fastened to the second partial section 232.

As an example instead of a limitation, a main plane of the extension part 222 is parallel to a main plane of the second partial section 232. The main plane in this application may be understood as a plane with a largest area on a corresponding component. For example, a surface that is of the extension part 222 and that faces the second partial section 232 is parallel to a surface that is of the second partial section 232 and that faces the extension part 222. In this way, the extension part 222 and the second partial section 232 may be stacked and then fastened, so that connection reliability can be improved.

Refer back to FIG. 6. The second structural member 30 may include a second fastening part 31 and a shaft sleeve 32. The second fastening part 31 is configured to be fastened to the second housing 121, and the shaft sleeve 32 is sleeved on the mandrel 22 and is configured to: support the mandrel 22 and allow the mandrel 22 to rotate around the pivotal line 241.

In some embodiments, the second fastening part 31 is fastened to or integrally formed with the shaft sleeve 32.

In some embodiments, the hinge component 203 may include two second structural members 30, and the two second structural members 30 are respectively located on two sides of the first structural member 20 (which may be specifically the connection part 23) in an axis direction of the pivotal line 241. In this way, the mandrel 22 is supported by the shaft sleeves 32 in the two second structural members 30. This helps ensure rotation reliability of the mandrel 22.

In this embodiment of this application, a specific manner of the fastened connection may be a detachable connection, for example, a threaded connection or a snap-fitted connection; or may be a non-detachable connection, for example, welding, riveting, or bonding. This is not limited in this application.

For further understanding, FIG. 8 is a diagram of unfolding and folding of the hinge component 203 in an assembled state. As shown in (a) in FIG. 8, the hinge component 203 is in an unfolded state. Correspondingly, an electronic device in which the hinge component 203 is used is in an unfolded state, and at least a part of the connection part 23 can be seen. As shown in (b) in FIG. 8, the hinge component 203 is in a folded state. Correspondingly, the electronic device in which the hinge component 203 is used is in a folded state, and the connection part 23 is accommodated in the second accommodation space and is not seen by the user. The flexible printed circuit 204 passes through the channel 242 disposed on the connection part 23. One end of the flexible printed circuit 204 is connected to a signal (for example, a screen end signal) on the side of the first device body component 201, and the other end is connected to a signal (for example, a system end signal) on the side of the second device body component 202, to complete a signal connection between the first device body component 201 and the second device body component 202.

In some embodiments, the first electronic element 113 includes at least one of a display, a display drive board, a camera, and a microphone.

In some embodiments, the second electronic element 128 includes at least one of a main board and a central processing unit (central processing unit, CPU).

As described above, in the electrical signal transmission solution provided in this application, the flexible printed circuit 204 is connected to the two device body components of the electronic device 200, so that the size of the hinge component 203 can be greatly reduced. For example, the thickness of the flexible printed circuit 204 can be as thin as 0.1 mm, and the size of the hinge component 203 can be controlled to be less than or equal to 15 mm in width and less than or equal to 2 mm in thickness. This greatly improves the appearance delicacy of the hinge component 203, and implements a delicate size of the hinge. In addition, because the metal wire in the flexible printed circuit 204 is very thin and may reach a micrometer level, a quantity of signals that can be transmitted by the flexible printed circuit 204 has large expansion space without affecting the appearance delicacy of the hinge component 203. In addition, the movable part of the flexible printed circuit 204 has the specific bending radius in both the motion state and the static state, so that a requirement on long-term unfolding and folding reliability of the electronic device can be met.

In some embodiments, the electronic device 200 may include one or more layers of flexible printed circuits 204. For example, a quantity of layers of the flexible printed circuit 204 included in the electronic device 200 is greater than or equal to 1 and less than or equal to 5.

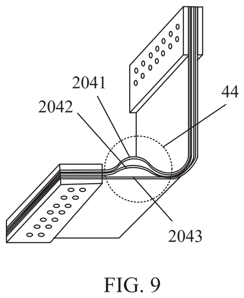

In some embodiments, refer to FIG. 9. When the electronic device 200 includes a plurality of layers of flexible printed circuits 204, the plurality of layers of flexible printed circuits 204 are stacked in an isolated manner in a motion region. Specifically, each layer of the plurality of layers of flexible printed circuits 204 includes the second section 44, the second section 44 is the motion region, and the plurality of second sections 44 included in the plurality of layers of flexible printed circuits 204 are isolated from each other and freely stacked, that is, are not press-fitted together. In other words, the plurality of second sections 44 may be separated from each other with the unfolding and folding motion of the electronic device 200 (or motion of the hinge component 203).

For example, the electronic device 200 may include a first flexible printed circuit 2041, a second flexible printed circuit 2042, and a third flexible printed circuit 2043. The second section 44 of the first flexible printed circuit 2041, the second section 44 of the second flexible printed circuit 2042, and the second section 44 of the third flexible printed circuit 2043 may be separated from each other in a motion process of the hinge component 203.

In this way, when the electronic device 200 is unfolded and folded, the plurality of flexible printed circuits 204 do not interfere with each other during motion, and the bending radius of the second section 44 and force applied to the metal wire are not affected, so that the flexible printed circuit meets a bending reliability requirement. In addition, when a quantity of transmitted signals is fixed, the width of the hinge component 203 can be further reduced by using the plurality of layers of flexible printed circuits. In addition, more transmitted signals can be added by using the plurality of layers of flexible printed circuits 204.

In some embodiments, the plurality of layers of flexible printed circuits 204 are fastened together in a non-motion region. Specifically, a part other than the second section 44 on each layer of the flexible printed circuit 204 is fastened to a corresponding part on another flexible printed circuit 204. For example, the two parts are mutually bonded or press-fitted under force.

For example, the first section 43 of the first flexible printed circuit 2041, the first section 43 of the second flexible printed circuit 2042, and the first section 43 of the third flexible printed circuit 2043 are fastened and stacked. The first end 41 of the first flexible printed circuit 2041, the first end 41 of the second flexible printed circuit 2042, and the first end 41 of the third flexible printed circuit 2043 are fastened and stacked. The second end 42 of the first flexible printed circuit 2041, the second end 42 of the second flexible printed circuit 2042, and the second end 42 of the third flexible printed circuit 2043 are fastened and stacked.

In some embodiments, signals transmitted between two layers of the plurality of layers of flexible printed circuits 204 may be the same or may be different. For example, the first flexible printed circuit 2041 and the second flexible printed circuit 2042 are used as an example. A signal transmitted by the first flexible printed circuit 2041 may be the same as or different from a signal transmitted by the second flexible printed circuit 2042. This is not limited in this application.

An embodiment of this application further provides a hinge component. The hinge component may include the related structure of the hinge component 203 and the flexible printed circuit 204.

An embodiment of this application further provides a flexible printed circuit. The flexible printed circuit may be the flexible printed circuit 204 described in the foregoing embodiments.

In conclusion, in embodiments of this application, the thin flexible printed circuit passes through the inside of the hinge, to reduce width and thickness space required by a conventional cable to pass through the inside of the hinge, so that the hinge is narrower and thinner, and more delicate appearance experience is implemented.

In the descriptions of this application, it should be noted that terms "mounting" and "connection" should be understood in a broad sense unless otherwise specified and limited. For example, a connection may be a fastened connection, a detachable connection, or an integrated connection; may be a mechanical connection or an electrical connection; and may be a direct connection, an indirect connection through an intermediate medium, or a connection inside two elements. A person of ordinary skill in the art may understand specific meanings of the terms in this application based on a specific situation.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising:
a first device body component, comprising a first housing and a first electronic element, wherein first accommodation space is formed on the first housing, and the first electronic element is accommodated in the first accommodation space;
a second device body component, comprising a second housing and a second electronic element, wherein second accommodation space is formed on the second housing, and the second electronic element is accommodated in the second accommodation space;
a hinge component, comprising a first structural member and a second structural member that are rotatably connected, wherein the second structural member is connected to the second housing, the first structural member is connected to the first housing, and a channel communicating the first accommodation space with the second accommodation space is disposed on the first structural member; and
a flexible printed circuit, comprising a first end, a second end, and a first section and a second section that are located between the first end and the second end, wherein the first end is connected to the first electronic element, the second end is connected to the second electronic element, the first section is located in the channel and is fastened to the first structural member, and the second section is located in the second accommodation space and a minimum bending radius of the second section is greater than or equal to a preset value.

2. The electronic device according to claim **1,** wherein rebound force of the flexible printed circuit is greater than or equal to 40 mN/mm and less than or equal to 100 mN/mm.

3. The electronic device according to claim 1 or 2, wherein the preset value is greater than or equal to five times a thickness of the flexible printed circuit.

4. The electronic device according to any one of claims 1 to 3, wherein the second section performs crawler motion with unfolding and folding motion of the electronic device.

5. The electronic device according to any one of claims 1 to 4, wherein a part other than the second section on the flexible printed circuit is relatively fastened.

6. The electronic device according to any one of claims 1 to 5, wherein the flexible printed circuit comprises a first cover film, a metal conductive layer, a substrate layer, and a second cover film that are stacked, the metal conductive layer is located between the first cover film and the substrate layer, and the substrate layer is located between the metal conductive layer and the second cover film.

7. The electronic device according to claim 6, wherein a material of the metal conductive layer is rolled annealed copper.

8. The electronic device according to claim 6 or 7, wherein the metal conductive layer is located on a bent inner side of the second section relative to the substrate layer.

9. The electronic device according to any one of claims 1 to 8, wherein the hinge component further comprises:
a wedge-shaped member, wherein the wedge-shaped member is disposed at an end part that is of the channel and that is located in the second accommodation space, and is located between the first section and an inner wall that is of the channel and that is away from a pivotal line of the hinge component.

10. The electronic device according to claim 9, wherein
the wedge-shaped member is wedged to the first structural member; or
the wedge-shaped member is fastened to the first structural member.

11. The electronic device according to claim 9 or 10, wherein the first structural member comprises a main body and a cover body, the main body and the cover body are snap-fitted to form the channel, and the wedge-shaped member is located between the first section and the first cover body.

12. The electronic device according to any one of claims 1 to 11, wherein the second section is U-shaped when the electronic device is in an unfolded state.

13. The electronic device according to any one of claims 1 to 12, wherein a protective film is disposed in a region that is on the second section and that is in contact with an inner wall of the second housing and/or a region that is on the second housing and that is in contact with the second section.

14. The electronic device according to any one of claims 1 to 13, wherein the first structural member comprises:
a first fastening part, connected to the first housing;
a mandrel, wherein an axis of the mandrel is the pivotal line of the hinge component; and
a connection part, connecting the first fastening part to the mandrel, wherein the channel is disposed at the connection part; and
the second structural member comprises:
a second fastening part, connected to the second housing; and
a shaft sleeve, sleeved on the mandrel, and configured to support the mandrel to rotate around the pivotal line.

15. The electronic device according to claim 14, wherein the connection part comprises a first partial section and a second partial section, the first partial section is connected to the first fastening part, the second partial section is connected to the mandrel, and there is a preset included angle between the first partial section and the second partial section.

16. The electronic device according to any one of claims 1 to 15, wherein the electronic device comprises one or more layers of flexible printed circuits, and second sections on adjacent flexible printed circuits in the plurality of layers of flexible printed circuits are separable from each other with the unfolding and folding motion of the electronic device.

17. The electronic device according to claim 16, wherein parts other than the second sections on the adjacent flexible printed circuits in the plurality of layers of flexible printed circuits are correspondingly fastened and stacked.

18. The electronic device according to any one of claims 1 to 17, wherein the first electronic element is any one of a display drive board, a camera, or a microphone, and the second electronic element is a main board.

19. A flexible printed circuit, wherein the flexible printed circuit is the flexible printed circuit according to any one of claims 1 to 18.
